# FASCICULE DE BREVET EUROPEEN

(11) **EP 3 503 223 B1**
(45) Date de publication et mention de la délivrance du brevet: **07.04.2021**
(21) Numéro de dépôt: 18213610.1
(22) Date de dépôt: 18.12.2018
(51) Int. Cl.: H01L 33/00

(54) **PROCEDE DE FABRICATION D'UNE HETEROSTRUCTURE COMPORTANT DES STRUCTURES ELEMENTAIRES ACTIVES OU PASSIVES EN MATERIAU III-V A LA SURFACE D'UN SUBSTRAT A BASE DE SILICIUM**
HERSTELLUNGSVERFAHREN EINER HETEROSTRUKTUR, DIE AKTIVE UND PASSIVE GRUNDSTRUKTUREN AUS III-V-HALBLEITERMATERIAL AUF DER OBERFLÄCHE EINES SUBSTRATS AUF SILIZIUMBASIS UMFASST
METHOD FOR MANUFACTURING A HETEROSTRUCTURE COMPRISING III-V MATERIAL ACTIVE OR PASSIVE ELEMENTARY STRUCTURES ON THE SURFACE OF A SUBSTRATE MADE OF SILICON

(30) Priorité: 20.12.2017 FR 1762569
(43) Date de publication de la demande: 26.06.2019
(73) Titulaire: Commissariat à l'Energie Atomique et aux Energies Alternatives, 75015 Paris (FR)
(72) Inventeur: NEMOUCHI, Fabrice, 38430 MOIRANS (FR); BAUDOT, Charles, 38660 LUMBIN (FR); BOGUMILOWICZ, Yann, 38100 GRENOBLE (FR); GHEGIN, Elodie, 38170 SEYSSINET-PARISET (FR); RODRIGUEZ, Philippe, 38690 LE GRAND-LEMPS (FR)
(74) Mandataire: Marks & Clerk France

(56) Documents cités:
- WO-A1-2011/061296
- WO-A1-2017/089676
- US-A1- 2013 252 361
- US-B1- 9 401 583
- US-B2- 8 173 551

## Description

Le domaine de l'invention est celui des composants III-V et concerne un procédé d'élaboration de structure pour les applications photoniques par exemple laser et plus particulièrement d'hétérostructure de couche III-V sur substrat silicium.

L'intégration hétérogène par exemple d'un laser III-V sur un substrat de SOI contenant des éléments passifs et actifs (guide d'onde, modulateur...) en silicium nécessite généralement le report de puces de matériaux III-V crus sur un substrat InP qui doivent être ensuite découpées et collées.

Actuellement ce report selon l'art connu peut être réalisé selon différents procédés mais utilise dans tous les cas l'utilisation d'un substrat en matériau III-V (généralement un substrat de phosphure d'indium) supportant les différentes couches épitaxiées nécessaires à l'obtention des composants en matériaux III-V.

Les étapes principales de réalisation sont :
1) la réalisation des puces III-V à partir d'un substrat par exemple d'InP typiquement de 4 pouces maximum sur lequel un empilement de couche III-V définissant les couches caractéristiques d'un laser ou un autre dispositif (photodétecteur,...) ont été épitaxiées (l'empilement des couches épitaxiées est inversé afin de coller dans le bon sens) ;
2) puis le report des ces couches est réalisé :
   - soit de manière collective en ayant découpé et placé des puces sur un support doté d'empreinte appelé couramment « holder » dédié, afin de les reporter sur le substrat ;
   - soit de manière individuelle en ayant préalablement découpé les puces de 1 à quelques millimètres carrés puis en reportant et en collant chaque puce de manière individuelle.

Dans tous les cas, les puces de matériaux III-V sont supportées par un substrat InP dont le diamètre initial du wafer est limité, nécessitant la suppression de la partie support (substrat InP) qui représente environ 98% de l'épaisseur.

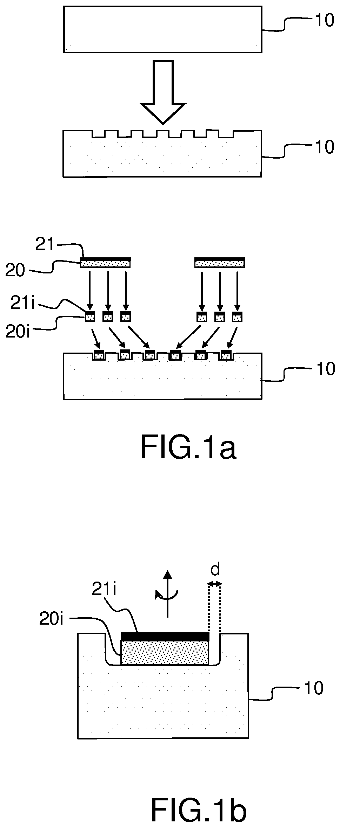

Les figures 1a à 1c illustrent l'utilisation d'un substrat porteur appelé « holder ».

Plus précisément la figure 1a illustre la réalisation de logements unitaires gravés dans un substrat dit holder **10,** la réalisation en parallèle d'au moins une couche **21** en matériau III-V à la surface d'un substrat **20** en matériau III-V et la découpe d'éléments **21i/20i** désigné par le terme puce dans l'ensemble de la présente description et reporté sur le « holder **» 10** comprenant des logements élémentaires pour recevoir chacun des ensembles **21i/20i.**

La figure 1b est une figure agrandie d'un ensemble unitaire **21i/20i** mettant en évidence la marge de désalignement **d** possible et la rotation possible de chacune des puces lors du report d'une puce dans un logement dédié.

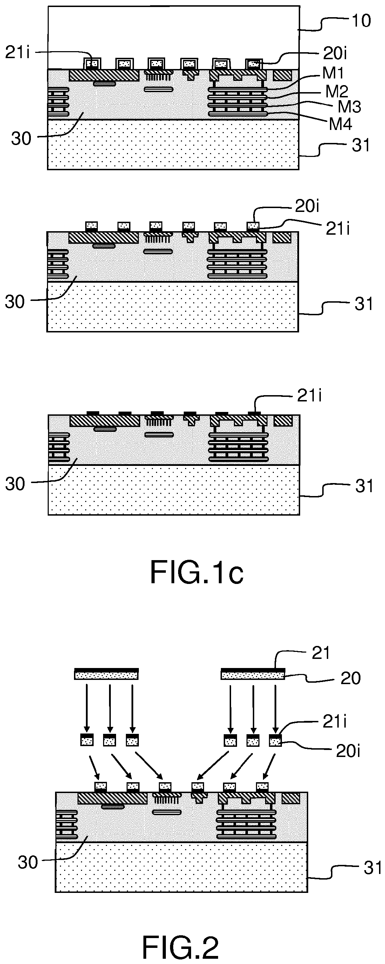

La figure 1c illustre le report collectif de l'ensemble des puces (dans le « holder ») à la surface, qui devient alors l'interface de collage **30,** d'un substrat de type SOI pouvant comprendre des éléments passifs et actifs (guide d'onde, modulateur,...) et des ensembles de métallisations. Ladite interface étant positionnée à la surface d'un support **31** dénommé poignée.

Il est nécessaire d'avoir une poignée car le substrat receveur a été, au préalable, aminci (en face arrière) de toute la partie silicium servant de support, le film de quelques µm d'épaisseur contenant les éléments actifs et passifs photoniques, d'un diamètre de 300 mm, ne pouvant pas être manipulé sans une telle poignée.

Les problématiques majeures rencontrées sont les suivantes :
- la nécessité de fabriquer le « holder », avec des coûts et des difficultés de réutilisation ;
- la mise en place des puces sur le « holder » nécessitant de cliver des plaques III-V avec des pertes ;
- le processus de mise en place des puces long et fastidieux ;
- le problème de désalignement pouvant typiquement être de 50 µm : plaque à plaque, de 100 à 150 µm : puces à « holder » (report collectifs) avec comme contrainte dans le meilleur des cas : 300 µm puces à plaque (dans le cadre du report individuel) ;
- le démontage du substrat « holder » entraînant le retrait du substrat III-V (ce qui engendre un coût) avec une décote latérale (pas de sélectivité chimique) ;
- une variabilité (taux de collage des puces et désalignement possible, plus effet potentiel de rotation comme illustré en figure 1b).

La figure 2 illustre, le report et le collage de puces **20i/21i** individuellement réalisées après découpe d'un substrat **20** de matériau III-V et épitaxie d'éléments **21** de matériaux III-V et positionnées sur une plaque comprenant le substrat de type SOI, comprenant une interface **30,** monté sur un support dit poignée **31.**

Dans ce cas les problématiques majeures sont :
- le besoin de cliver des plaques III-V (pertes) ;
- la mise en place des puces (long) ;
- la précision d'alignement : 50 µm plaque à plaque ;
- la variabilité puce à puce ;
- le démontage substrat : avec le retrait du substrat III-V (coût) et une décote latérale (pas de sélectivité chimique) ;
- la variabilité : taux de collage des puces et désalignement plus rotation.

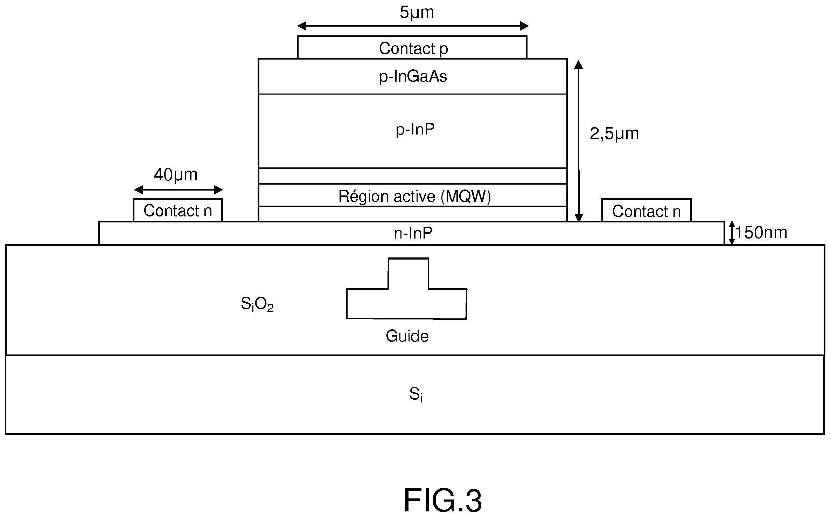

La figure 3 illustre de manière détaillée une structure élémentaire active photonique réalisée dans l'invention, qui peut être de type laser et rappelle les dimensions caractéristiques d'un tel laser III-V. L'empilement multicouche III-V présente une hauteur typiquement de 2 à 5 µm de hauteur et une largeur pouvant typiquement être comprise entre 40 et 90 µm de large. Un guide en Si est intégré dans une couche d'oxyde SiO₂ réalisée à la surface d'un substrat Si. La figure 3 met en évidence, les contacts de type n sur une couche de base n-InP, une structure en mesa comprenant l'empilement de la région active constituée d'une structure à multi-puits quantique sur laquelle est empilée une couche p-InP, une couche p-InGaAs et le contact de type p.

Il est connu de la demande de brevet US 2013/252361, un procédé de fabrication d'une hétérostructure présentant des opérations successives d'épitaxie.

Il est connu de la demande de brevet WO 2017/089676, un procédé de réalisation d'hétérostructure et comprenant des opérations de report.Dans ce contexte et pour résoudre les inconvénients précités, la présente invention a pour objet un procédé utilisant un substrat couramment appelé wafer, pouvant être de silicium ou SOI comme substrat de croissance (ou encore identifié comme substrat donneur) en remplacement d'un substrat en matériau III-V (généralement InP). Le Demandeur exploite pour cela une technique décrite notamment dans le brevet US 8 173 551 et comprenant l'épitaxie de matériau III-V sur un premier substrat de silicium, de manière à préconstituer des substrats élémentaires de matériaux III-V (et non plus d'utiliser des substrats massifs de matériaux III-V), sur lesquels peuvent être réalisées des couches actives constitutives par exemple d'un laser, avant de procéder au report de l'ensemble sur un second substrat pouvant comprendre des éléments passifs et actifs (guide d'onde, modulateur...).

Le procédé de l'invention présente notamment les avantages suivants :
- l'utilisation d'un substrat moins coûteux et plus facile à retirer ;
- la localisation des structures épitaxiées, ainsi les structures peuvent être reportées de manière collective ;
- l'utilisation de structures élémentaires de type notamment laser pouvant être pré-alignées sur une plaquette « donneur », l'alignement des puces entre elles étant à une précision liée à la lithographie ;
- lors du report, un seul alignement plaque à plaque permettant d'obtenir une précision dans une gamme pouvant typiquement être de 10 µm à 80 µm avec une moyenne à 50 µm ;
- l'obtention d'une pré-encapsulation des puces en matériau III-V dans un diélectrique.

Plus précisément la présente invention a pour objet un procédé de fabrication d'une hétérostructure comportant au moins une structure élémentaire en matériau III-V à la surface d'un substrat à base de silicium comprenant successivement :
- la réalisation d'un premier motif présentant au moins une première ouverture dans un matériau diélectrique à la surface d'un premier substrat à base de silicium ;
- une première opération d'épitaxie d'au moins un matériau III-V de manière à définir au moins une couche de base élémentaire en matériau III-V dans ladite au moins première ouverture ;
- la réalisation d'un second motif dans un matériau diélectrique de manière à définir au moins une seconde ouverture présentant un recouvrement avec ladite au moins couche de base élémentaire en matériau III-V ;
- une seconde opération d'épitaxie d'au moins un matériau III-V à la surface de ladite au moins couche de base élémentaire en matériau III-V de manière à réaliser ladite au moins structure élémentaire en matériau(x) III-V présentant une face externe ;
- une opération de report et d'assemblage de ladite au moins structure élémentaire via sa face externe, sur une interface pouvant comporter des éléments passifs et/ou des éléments actifs, ladite interface étant réalisée à la surface d'un second substrat à base de silicium ;
- le retrait dudit premier substrat à base de silicium et de ladite au moins couche de base élémentaire en matériau III-V située sur ladite structure élémentaire.

Selon des variantes de l'invention, ladite au moins structure élémentaire est une structure élémentaire photonique active (structure Laser avec des longueurs d'onde différentes, modulateur, photodétecteur ...).

Selon des variantes de l'invention, ladite au moins structure élémentaire est une structure élémentaire passive (guide d'onde, multiplexeur, ...).

Selon des variantes de l'invention, ladite hétérostructure peut comporter au moins une structure élémentaire photonique active et au moins une structure élémentaire passive.

Il peut avantageusement être prévu des opérations de planarisation ou polissage mécano-chimique (CMP), et ce afin de retirer par exemple les éventuelles couches de matériaux III-V non actives situées au dessus du plan de surface du motif et afin d'obtenir une surface de collage constituée d'un plan unique et répondant aux critères de collages (planéité, rugosité...), cette opération étant préalable à l'opération de report et d'assemblage.

La première opération d'épitaxie peut avantageusement être suivie par une opération de polissage et ce avant la réalisation du second motif, cette opération de polissage pouvant être de type mécano-chimique (CMP), permettant d'ôter l'excès de matériau (x) III/V débordant du motif.

L'étape de polissage consécutif à la seconde opération d'épitaxie peut assurer deux fonctions, enlever l'excès de matière III-V et préparer la surface avant collage. Il peut s'agir de deux procédés distincts utilisant des chimies et conditions de process différents.

Le substrat peut typiquement être en Si, SOI, Si₁₋ₓGeₓ avec 0 < x < 1.

Selon des variantes de l'invention, la réalisation dudit premier motif comprend :
- la réalisation d'au moins une ouverture primaire présentant au moins une partie verticale inférieure et une partie horizontale supérieure, ladite partie verticale étant décentrée par rapport à ladite partie horizontale ;
- la réalisation d'au moins une couche de base élémentaire comprenant une partie verticale inférieure et une partie horizontale ;
- la réalisation d'au moins ladite structure élémentaire active photonique à la surface de la partie horizontale de ladite couche de base élémentaire en matériau III-V, de manière décentrée par rapport à la partie verticale inférieure de ladite au moins couche de base élémentaire en matériau III-V.

Selon des variantes de l'invention, la réalisation dudit premier motif comprend la réalisation d'au moins une ouverture primaire complexe présentant au moins :
- une partie verticale inférieure ;
- une partie horizontale intermédiaire ;
- une partie verticale supérieure ;
- lesdites parties verticales inférieure et supérieure étant décentrées de manière opposée par rapport à ladite partie horizontale ;
- ladite première opération d'épitaxie définissant au moins une couche de base élémentaire en matériau III-V primaire présentant au moins une partie verticale inférieure et une partie horizontale.

Selon des variantes de l'invention, le procédé comprend pour réaliser ladite au moins première ouverture complexe :
- la réalisation de ladite partie verticale inférieure et de ladite partie horizontale intermédiaire ;
- le dépôt d'un matériau sacrificiel dans ladite partie verticale inférieure et dans ladite partie horizontale intermédiaire de manière à définir au moins un élément sacrificiel intermédiaire ;
- le dépôt d'une couche supérieure de diélectrique ;
- la réalisation d'au moins ladite partie verticale supérieure de ladite première ouverture dans ladite couche supérieure de diélectrique de manière à former au moins ladite première ouverture complexe ;
- l'épitaxie de matériau III-V dans ladite au moins ouverture primaire complexe, de manière à former ladite au moins couche élémentaire de base.

Le matériau sacrificiel peut avantageusement être du Si₁₋ₓGeₓ avec 0 < x < 1 polycristallin ou amorphe. Avantageusement, son retrait peut être effectué dans un mélange HCI gazeux et dihydrogène à température élevée (typiquement > 500°C, la température choisie dépendant de la concentration en Ge de ladite couche sacrificielle).

Avantageusement, ladite opération d'assemblage comprend une opération de collage, pouvant être une opération de collage moléculaire.

La présente invention a aussi pour objet un procédé de réalisation d'une multiplicité de dispositifs III-V sur un même support, le report de ces dispositifs se faisant collectivement et permettant des gains significatifs dans les alignements. L'alignement relatif des dispositifs entre eux provient de la précision des procédés de photo- lithographie.

Plus précisément, ce procédé comprenant la réalisation d'un ensemble de premiers motifs présentant des premières ouvertures dans un matériau diélectrique à la surface d'un premier substrat à base de silicium ;
- une première opération d'épitaxie d'au moins un matériau III-V de manière à définir au moins un ensemble de couches de base élémentaires en matériau III-V dans lesdites premières ouvertures ;
- la réalisation d'un ensemble de seconds motifs dans un matériau diélectrique de manière à définir un ensemble de secondes ouvertures présentant un recouvrement avec lesdites couches de base élémentaires en matériau III-V ;
- une seconde opération d'épitaxie d'au moins un matériau III-V à la surface desdites couches de base élémentaires en matériau III-V de manière à réaliser lesdites structures élémentaires en matériau(x) III-V présentant une face externe ;
- une opération de report et d'assemblage de l'ensemble des structures élémentaires via leur face externe, sur une interface (300) pouvant comporter des éléments passifs et/ou des éléments actifs, ladite interface étant réalisée à la surface d'un second substrat à base de silicium (301) ;
- le retrait dudit premier substrat à base de silicium et de l'ensemble des couches de base élémentaires en matériau III-V située sur lesdites structures élémentaires.

Les étapes d'épitaxie peuvent avantageusement être suivies d'opération de polissage, pouvant être de type mécano-chimique (CMP).

Ainsi, la première opération d'épitaxie peut être suivie par une opération de polissage et ce avant la réalisation des seconds motifs, cette opération de polissage pouvant être de type mécano-chimique (CMP), permettant d'ôter l'excès de matériau (x) III/V débordant des motifs.

Une étape de polissage consécutif à la seconde opération d'épitaxie peut assurer deux fonctions, enlever l'excès de matière III-V et préparer la surface avant collage. Il peut s'agir de deux procédés distincts utilisant des chimies et conditions de process différents.

L'invention a aussi pour objet un procédé dans lequel on réalise plusieurs structures élémentaires différentes fonctionnant à des longueurs d'onde différentes.

Pour ce faire, ledit procédé peut comprendre des opérations successives d'épitaxie pour réaliser les différentes structures élémentaires, par exemple des structures élémentaires actives photoniques fonctionnant à des longueurs d'onde différentes, lesdites opérations étant effectuées successivement à des températures d'épitaxie décroissantes.

Avantageusement, l'interface présente un support couramment dénommé « poignée » sur une face opposée audit second substrat. L'invention a ainsi pour objet un procédé selon l'invention dans lequel ledit second substrat à base de silicium est retiré avant assemblage pour laisser à nu, l'interface pouvant comporter des éléments passifs et/ou actifs, ladite interface étant à la surface dudit support.

Selon des variantes de l'invention, pour réaliser des structures élémentaires actives photoniques, on réalise avantageusement des structures à multi-puits quantique en matériau(x) III-V.

Selon des variantes de l'invention, la couche de base élémentaire en matériau III-V peut avantageusement être InP.

L'invention sera mieux comprise et d'autres avantages apparaîtront à la lecture de la description qui va suivre donnée à titre non limitatif et grâce aux figures parmi lesquelles :
- les figures 1a à 1c illustrent un premier exemple de procédé de report de puces en matériau(x) III-V sur un substrat SOI comprenant l'utilisation d'un « holder » selon l'art connu ;
- la figure 2 illustre un second exemple de procédé de report de puces sur un substrat SOI comprenant le collage individuel de puces en matériau(x) III-V selon l'art connu ;
- la figure 3 illustre les dimensions typiques d'une puce de type laser en matériaux III-V selon l'art connu ;
- les figure 4a à 4f illustrent les principales étapes d'un premier exemple de procédé selon l'invention ;
- la figure 5 illustre les différentes étapes d'un second exemple de procédé de l'invention comprenant la réalisation d'un motif primaire présentant des premières ouvertures complexes permettant de décentrer des structures élémentaires actives photoniques par rapport aux substrats élémentaires en matériau III-V ;
- la figure 6 illustre l'opération de report et d'assemblage des structures élémentaires actives photoniques obtenues selon les opérations décrites en figure 5 ;
- les figures 7a à 7d montrent des vue de dessus et des vues transverses mettant en évidence les dimensions de structures élémentaires actives photoniques dans un procédé selon l'invention ;
- la figure 8 illustre un exemple d'étapes successives de fabrication de structures élémentaires différentes selon le procédé de l'invention ;
- la figure 9 illustre un ensemble de structures élémentaires actives photoniques différentes.

La présente invention est décrite plus en détails dans le cadre de structure(s) élémentaire(s) photonique(s) active(s), mais peut également être appliquée dans le cadre de structure(s) élémentaire(s) passive(s).

Le procédé de l'invention exploite le procédé d'épitaxie par piégeage de défaut cristallin (lié à la différence de paramètre de maille) permettant d'utiliser un substrat de base en matériau semi-conducteur tel que du silicium sur lequel on réalise préalablement des couches de base élémentaires en matériau III-V destinées à la croissance épitaxiale de structures élémentaires actives photoniques telles que par exemple des structures de multi-puits quantiques dont le choix de la nature des couches et leur épaisseurs déterminent les longueurs d'onde de fonctionnement.

Les couches de base élémentaires en matériau III-V peuvent être réalisées avec des hauts facteurs de forme permettant avantageusement de piéger des défauts liés à l'hétérostructure. Les techniques de croissance à haut facteur de forme ont notamment été décrites dans le brevet US 8 173 551.

Le procédé de l'invention peut être décliné selon aux moins les deux alternatives suivantes et qui sont détaillées dans la suite de la description :
- première alternative : le procédé comprend deux séquences d'opération de lithographie et d'épitaxie de matériau(x) III-V ;
- seconde alternative : le procédé comprend la fabrication d'un motif particulier avec utilisation d'une couche sacrificielle, dans lequel une opération d'épitaxie de matériau(x) III-V est réalisée.

Le Demandeur décrit ci-après différents exemples de procédé selon l'invention.

### Exemple de procédé de l'invention selon la première alternative :

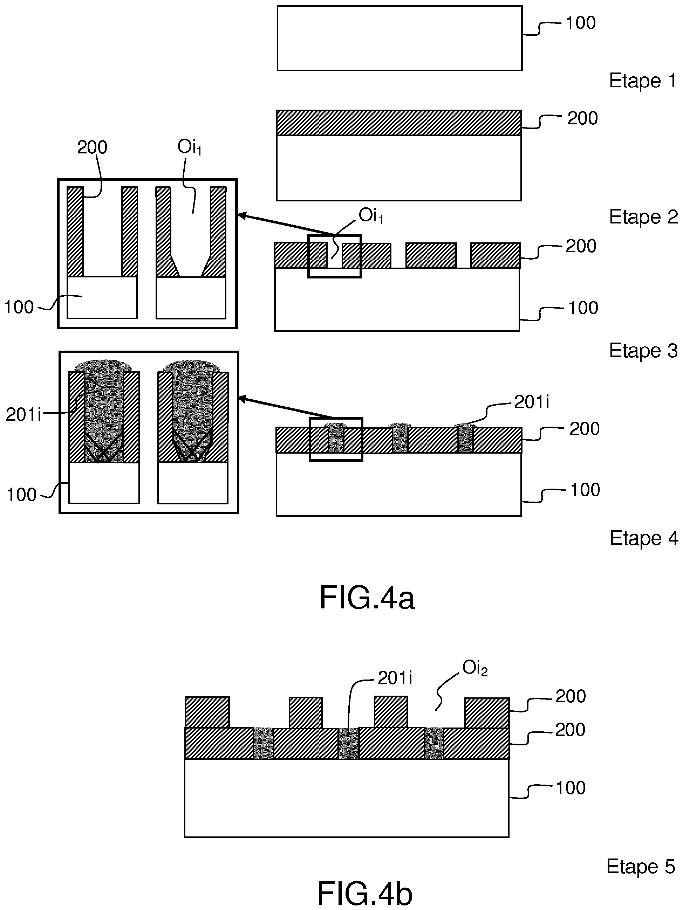

La figure 4a illustre les premières étapes suivantes :
Etape 1 : on utilise un premier substrat **100** de faible coût en silicium.
Etape 2 : à partir de ce premier substrat **100,** on réalise une couche de diélectrique **200.**
Etape 3 : on réalise des ouvertures **O₁ᵢ** dans la couche **200** de manière à définir un motif avec des ouvertures comme illustré en figure 4a. Le carré montre un agrandi mettant en évidence le type de flancs, droits ou biseautés pouvant être obtenus dans les ouvertures.
Etape 4 : on procède à une première opération d'épitaxie de matériau III-V pouvant être de l'InP de manière à définir des couches de base élémentaires en matériau III-V : **201i.**

La figure 4b illustre l'étape 5 : après avoir procédé à une opération de planarisation de type CMP (de polissage mécanique/chimique), on procède au dépôt d'une seconde couche de diélectrique **200** dans laquelle on réalise des secondes ouvertures **Oᵢ₂** de manière à définir un second motif.

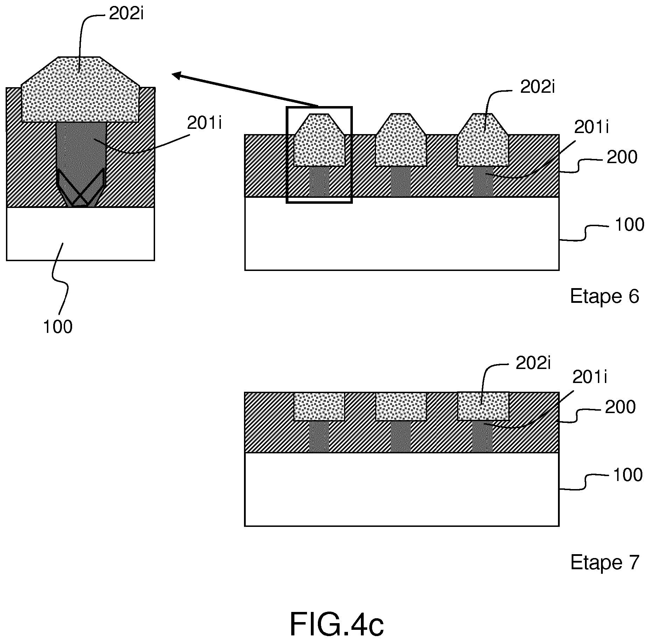

La figure 4c illustre l'étape 6 : on réalise une seconde opération d'épitaxie de matériau(x) III-V de manière à définir des structures élémentaires actives photoniques **202i,** puis l'on procède en l'étape 7 à une opération de planarisation.

Les secondes ouvertures ont des largeurs supérieures à celles des premières ouvertures de manière à permettre la croissance latérale de matériau(x) III-V à partir des substrats de matériaux III-V. Les défauts de croissance peuvent avantageusement être confinés dans les cavités (les dislocations sont stoppées par les parois de la cavité) des substrats et permettre de réaliser une croissance de matériau(x) III-V à partir des substrats **201i.** Typiquement, à partir d'un substrat Si, les défauts liés à la relaxation des couches se retrouvent principalement dans les plans cristallins {111} formant un angle de 54,7° avec la surface du substrat. Donc, si la hauteur de la cavité O₁ᵢ est supérieure à tan (54,7°) on peut confiner les défauts de ces plans, typiquement, si la hauteur est supérieure à 1,4 fois la largeur de la cavité. Plus ce rapport est grand, et plus l'effet de confinement est élevé.

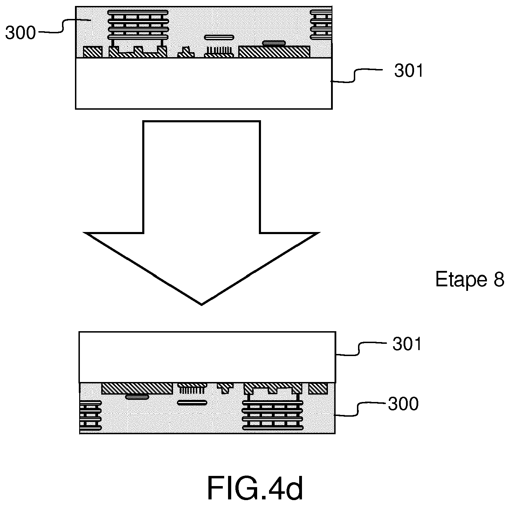

La figure 4d illustre le second substrat employé dans le procédé de l'invention. Ce substrat peut être de type SOI pouvant comprendre des éléments passifs et actifs (guide d'onde, modulateur,...) et des ensembles de métallisations. Il comporte une partie silicium **301** et une partie intégrant les composants passifs ou actifs **300** destinée à adresser la ou les structures élémentaires actives photoniques élaborées à la surface du premier substrat **100,** ledit second substrat étant présenté retourné (Etape 8) pour réaliser l'opération d'assemblage.

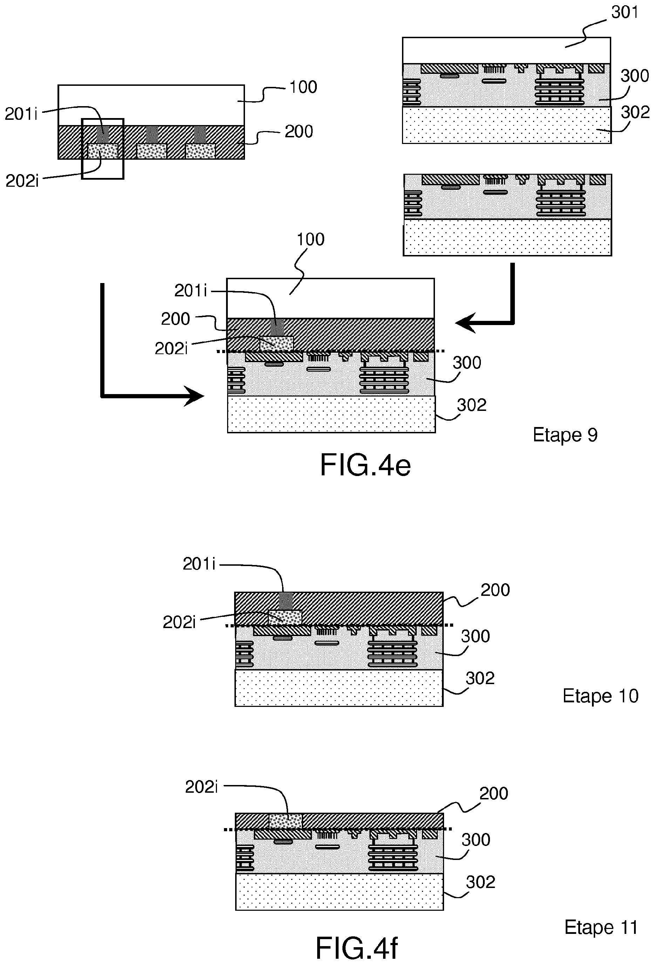

Etape 9 : Pour les besoins du report, ce second substrat est positionné sur un support appelé poignée **302** et l'on procède à l'opération d'assemblage avec la ou les structures élémentaires réalisées en parallèle, comme illustré en figure 4e. Typiquement, l'opération d'assemblage peut être réalisée grâce à une opération de collage moléculaire.

Etape 10 : on procède au retrait de la partie inférieure **100** du premier substrat comme illustré en figure 4f, mettant à nu les substrats élémentaires **201i** par une opération d'amincissement mécanique, puis nettoyage comme illustré en figure 4f.

Etape 11 : on procède enfin au retrait de la partie du substrat comprenant le diélectrique **200** et les couches de base élémentaires en matériau III-V **201i,** pour dégager les structures élémentaires actives photoniques **202i** comme illustré également en figure 4f.

### Exemple de procédé de l'invention selon la seconde alternative :

Avantageusement, la couche de base élémentaire en matériau III-V peut être réalisée de manière à comprendre une première partie inférieure verticale étroite pouvant piéger les défauts de croissance à partir du premier substrat et une partie horizontale supérieure plus large, ladite partie inférieure étant décentrée par rapport à ladite partie horizontale, pour pouvoir réaliser la croissance de la structure élémentaire active photonique de manière déportée.

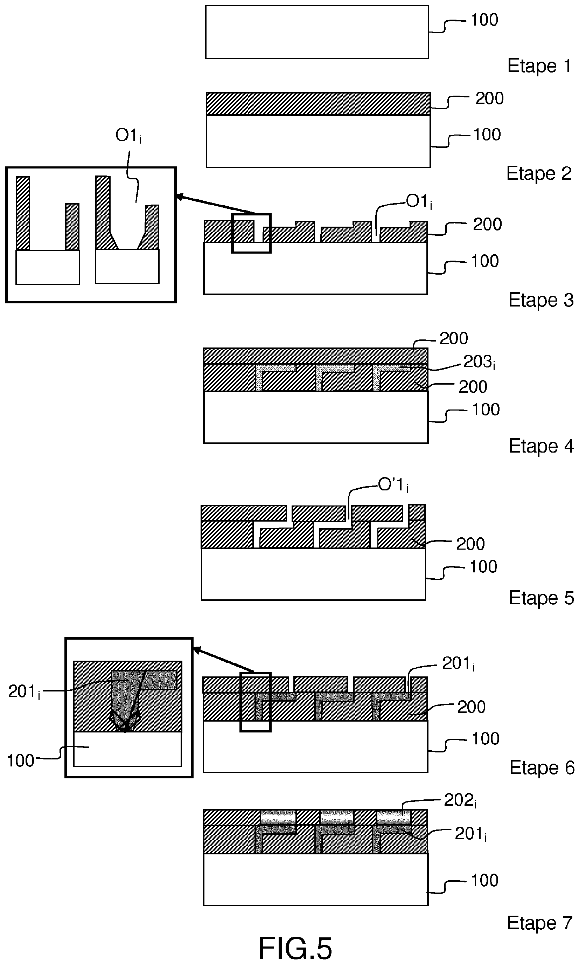

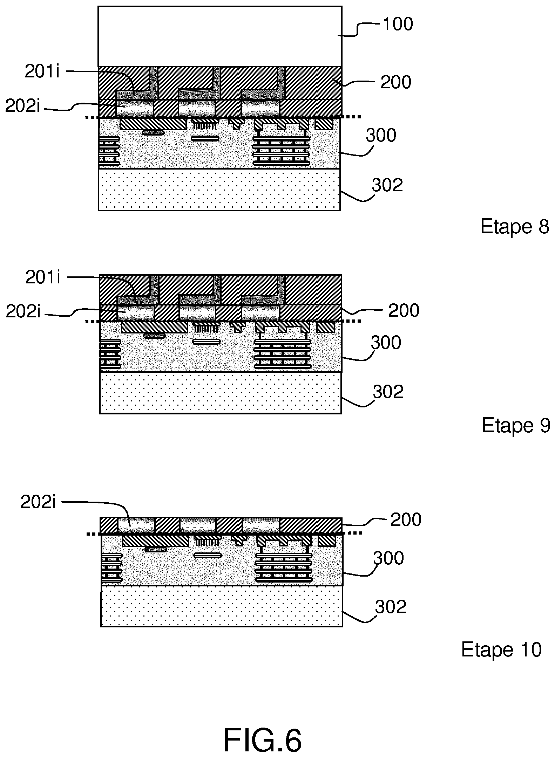

La figure 5 illustre les différentes étapes de ce second exemple de procédé :
Etape 1 : on utilise un premier substrat **100** de faible coût en silicium.
Etape 2 : à partir de ce premier substrat **100,** on réalise une couche de diélectrique **200.**
Etape 3 : on réalise des ouvertures **O_{1ι}** dans la couche **200** de manière à définir un motif avec des ouvertures, présentant une partie inférieure verticale et une partie horizontale, ladite partie verticale inférieure étant décentrée par rapport à ladite partie horizontale. Le carré montre un agrandi mettant en évidence le type de flancs, droits ou biseautés pouvant être obtenus dans la partie inférieur verticale des ouvertures.
Etape 4 : on procède au dépôt d'un matériau sacrificiel de manière à définir des éléments **203i** dans les ouvertures préalablement formées. On dépose alors une couche de diélectrique **200.**
Etape 5 : on vient définir dans la couche de diélectrique **200,** de nouvelles ouvertures constituant la partie verticale supérieure des premières ouvertures complexes **O'₁ᵢ,** en procédant au retrait également du matériau sacrificiel.
   L'intérêt de cette première ouverture complexe réside dans le fait que la partie horizontale est partiellement recouverte de diélectrique permettant d'éviter une étape ultérieure de type CMP pour uniformiser la surface de la couche de base élémentaire en matériau III-V.
Etape 6 : on procède à une première opération d'épitaxie de matériau III-V permettant de constituer les couches de base élémentaires en matériau III-V **201i.** Le carré met en évidence l'aspect déporté des dislocations dans la partie verticale inférieure de la couche élémentaire de base par rapport à la partie horizontale de ladite couche élémentaire de base.
Etape 7 : on procède à la réaliser de secondes ouvertures (non représentées) dans lesquelles on procède à de nouvelles opérations d'épitaxie afin de réaliser les structures élémentaires actives photoniques **202i.**
   Les étapes suivantes de report du second substrat à base de silicium et de composants actifs et/ou passifs peuvent être identiques à celles du premier exemple de procédé précédemment décrites et sont illustrées en figure 6 qui illustre les étapes suivantes :
Etape 8 : les deux substrats comportant d'une part les couches de base élémentaires en matériau III-V et d'autre part le support comprenant une interface avec des composants actifs et/ou passif sont assemblés et collés.
Etape 9 : on procède au retrait de la partie **100** du premier substrat, mettant à nu les couches de base élémentaires en matériau III-V **201i** par une opération d'amincissement mécanique.
Etape 10 : on procède enfin au retrait de la partie du substrat supérieur comprenant le diélectrique **200,** et les couches de base élémentaires en matériau III-V **201i** pour dégager les structures élémentaires actives photoniques **202i.**

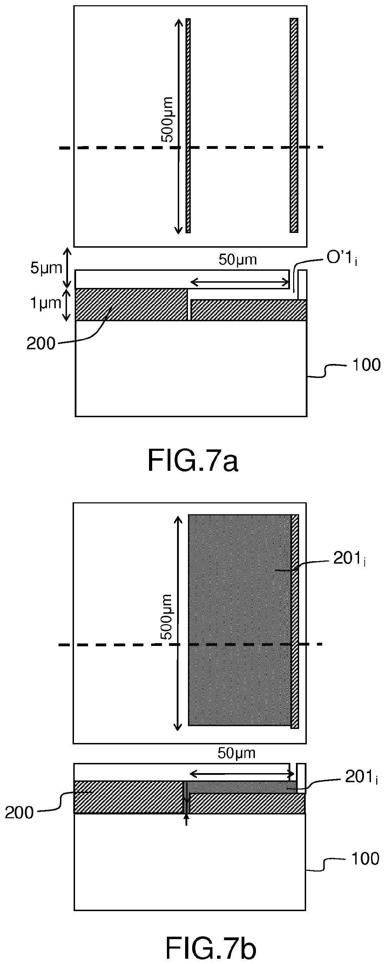

Des exemples de dimensions des structures élémentaires actives photoniques pouvant être réalisées selon le procédé de l'invention sont illustrées grâce aux figures 7a à 7e.

Typiquement, les premières ouvertures complexes **O'₁ᵢ** peuvent présenter des surfaces de 50 à 100 µm x 500 µm.

Les épaisseurs des couches de diélectriques successives permettant de définir lesdites premières ouvertures complexes peuvent être respectivement de 1 µm et 5 µm, comme illustré en figure 7a.

La figure 7b met en évidence la réalisation d'une couche de base élémentaire en matériau III-V en InP déposé par épitaxie dans ladite ouverture complexe. L'épaisseur de InP peut typiquement être comprise entre 5 à 10 µm avec des effets de charge compris entre 5 et 10.

De manière générale, l'effet de charge correspond à la différence d'épaisseur observée lorsqu'un même procédé d'épitaxie est réalisé sur (i) un substrat sans motifs (ii) un substrat avec motif, c'est-à-dire partiellement recouvert par un matériau de motif type SiO2.

L'épaisseur obtenue est souvent supérieure dans le cas (ii). Le rapport épaisseur dans le cas (ii) sur épaisseur obtenue dans le cas (i) définit l'effet de charge.

Dans la présente invention, une épaisseur équivalente de 5 à 10µm sur un substrat sans motif doit permettre de réaliser une croissance latérale de 10 à 50 µm dans les cavités en croissance latérale sur un substrat avec motif, bénéficiant donc de la présence de l'effet de charge.

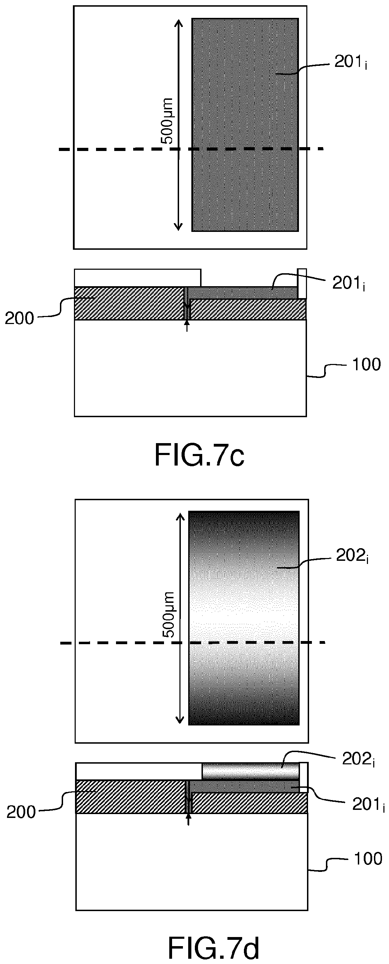

La figure 7c met en évidence la réalisation d'une seconde ouverture de manière classique par photolithographie.

La figure 7d met en évidence la croissance épitaxiale de la structure élémentaire active photonique en matériau(x) III-V, pouvant présenter une épaisseur typiquement comprise entre quelques nanomètres et quelques microns selon les applications visées.

Le procédé de la présente invention permet de séquencer des opérations d'épitaxie localisées, permettant ainsi de réaliser des structures élémentaires actives photoniques différentes, et notamment constituées de différents matériaux III-V ou différentes structures multi-puits quantiques, de manière à fabriquer au sein d'une même ensemble plusieurs fonctions photoniques différentes pouvant fonctionner à des longueurs d'onde différentes.

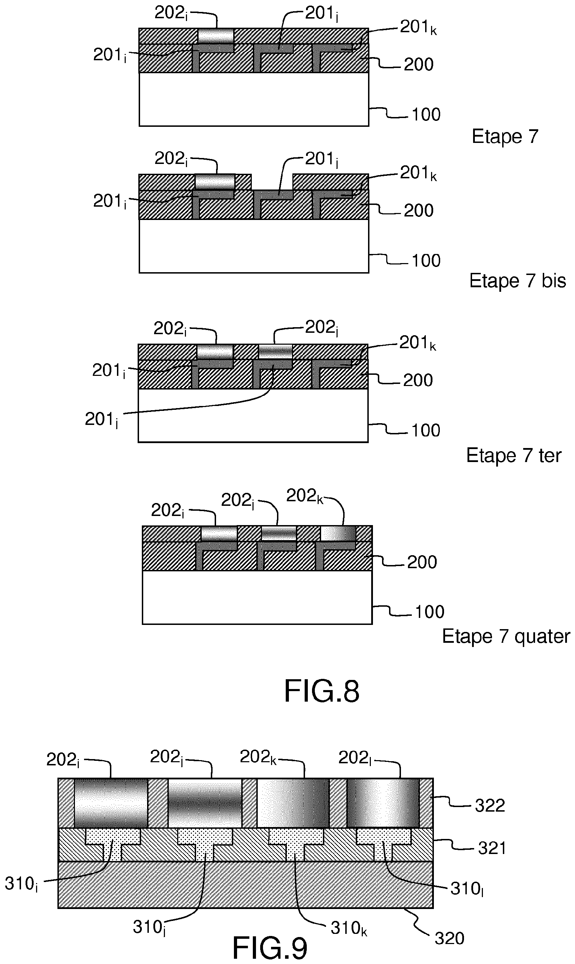

La figure 8 met en évidence les étapes 7, 7bis, 7 ter et 7 quater correspondantes à l'étape 7 du procédé décrit en figure 5 et relative à des étapes successives d'épitaxie permettant la formation de structures élémentaires différentes **202i, 202j, 202k** à partir des couches de base élémentaires en matériau III-V: **201i, 201j, 201k** et en procédant à des opérations de masquage différentes. L'étape 7bis met ainsi en évidence qu'après avoir réalisé une première opération de croissance épitaxiale pour élaborer la structure élémentaire **202i,** on réalise une opération de masquage destinée à la croissance épitaxiale de la structure élémentaire **202j.**

La figure 9 illustre un exemple de configuration mettant en évidence 4 structures élémentaires actives photoniques différentes **202i, 202j, 202k, 202l** comprenant des multi-puits quantiques entre couches de matériaux III-V et assemblées, au niveau d'éléments de guide en silicium respectivement **310i, 310j, 310k, 310l** réalisés dans le substrat **300** comprenant trois niveaux de diélectrique de SiO₂ **320, 321** et **322,** la couche **322** encapsulant avantageusement les 4 structures élémentaires actives photoniques.

Il pourrait également s'agir de composants différents (lasers, photodétecteur, modulateur en III-V.

Selon le procédé de l'invention, il est ainsi possible de réaliser grâce à chacune des opérations d'épitaxie un composant optimisé : laser/modulateur/ photodétecteur, de taille de l'ordre de quelques dizaines de microns.

## Revendications

1. Procédé de fabrication d'une hétérostructure comportant au moins une structure élémentaire en matériau III-V à la surface d'un substrat à base de silicium comprenant successivement :
- la réalisation d'un premier motif présentant au moins une première ouverture (Oᵢ₁) dans un matériau diélectrique (200) à la surface d'un premier substrat à base de silicium (100) ;
- une première opération d'épitaxie d'au moins un matériau III-V de manière à définir au moins une couche de base élémentaire en matériau III-V (201i) dans ladite au moins première ouverture ;
- la réalisation d'un second motif dans un matériau diélectrique (200) de manière à définir au moins une seconde ouverture (Oᵢ₂) présentant un recouvrement avec ladite au moins couche de base élémentaire en matériau III-V ;
- une seconde opération d'épitaxie d'au moins un matériau III-V à la surface de ladite au moins couche de base élémentaire en matériau III-V de manière à réaliser ladite au moins structure élémentaire en matériau(x) III-V présentant une face externe ;
- une opération de report et d'assemblage de ladite au moins structure élémentaire via sa face externe, sur une interface (300) pouvant comporter des éléments passifs et/ou des éléments actifs, ladite interface étant réalisée à la surface d'un second substrat à base de silicium (301) ;
- le retrait dudit premier substrat à base de silicium et de ladite au moins couche de base élémentaire en matériau III-V située sur ladite structure élémentaire.

2. Procédé selon la revendication 1, dans lequel ladite au moins structure élémentaire est une structure élémentaire photonique active.

3. Procédé selon l'une revendications 1 ou 2, dans lequel ladite au moins structure élémentaire est une structure élémentaire passive.

4. Procédé selon l'une des revendications 1 à 3, comprenant des opérations de polissage pouvant être de type mécano-chimique (CMP), réalisées après les opérations d'épitaxie.

5. Procédé selon la revendication 4, comprenant une opération de polissage mécano-chimique (CMP) préalable à l'opération de report et d'assemblage.

6. Procédé selon l'une des revendications 1 à 5, dans lequel la réalisation dudit premier motif comprend :
- la réalisation d'au moins une ouverture primaire présentant au moins une partie verticale inférieure et une partie horizontale supérieure, ladite partie verticale étant décentrée par rapport à ladite partie horizontale ;
- la réalisation d'au moins une couche de base élémentaire en matériau III-V comprenant une partie verticale inférieure et une partie horizontale ;
- la réalisation d'au moins ladite structure élémentaire active photonique à la surface de la partie horizontale de ladite couche de base élémentaire en matériau III-V, de manière décentrée par rapport à la partie verticale inférieure de ladite au moins couche de base élémentaire en matériau III-V.

7. Procédé selon la revendication 6, dans lequel la réalisation dudit premier motif comprend la réalisation d'au moins une ouverture primaire complexe (O'ᵢ₁) présentant au moins :
- une partie verticale inférieure ;
- une partie horizontale intermédiaire ;
- une partie verticale supérieure ;
- lesdites parties verticales inférieure et supérieure étant décentrées de manière opposée par rapport à ladite partie horizontale ;
- ladite première opération d'épitaxie définissant au moins une couche de base élémentaire en matériau III-V primaire présentant au moins une partie verticale inférieure et une partie horizontale.

8. Procédé selon la revendication 7, comprenant :
- la réalisation de ladite partie verticale inférieure et de ladite partie horizontale intermédiaire ;
- le dépôt d'un matériau sacrificiel dans ladite partie verticale inférieure et dans ladite partie horizontale intermédiaire de manière à définir au moins un élément sacrificiel intermédiaire (203i) ;
- le dépôt d'une couche supérieure de diélectrique (200) ;
- la réalisation d'au moins ladite partie verticale supérieure de ladite première ouverture dans ladite couche supérieure de diélectrique de manière à former au moins ladite première ouverture complexe (O'1i) ;
- l'épitaxie de matériau III-V dans ladite au moins ouverture primaire complexe, de manière à former ladite au moins ladite couche de base élémentaire en matériau III-V (201i).

9. Procédé selon la revendication 8, dans lequel le matériau sacrificiel est du Si₁₋ₓGeₓ avec 0 < x < 1, polycristallin ou amorphe.

10. Procédé selon la revendication 9, dans lequel le retrait dudit matériau sacrificiel est effectué dans un mélange HCI gazeux et dihydrogène à température supérieure à 500°C.

11. Procédé selon l'une des revendications 1 à 9 dans lequel ladite opération d'assemblage comprend une opération de collage.

12. Procédé selon la revendication 11, dans lequel ladite opération de collage est une opération de collage moléculaire.

13. Procédé selon l'une des revendications précédentes comprenant :
- la réalisation d'un ensemble de premiers motifs présentant des premières ouvertures (Oᵢ₁) dans un matériau diélectrique (200) à la surface d'un premier substrat à base de silicium (100) ;
- une première opération d'épitaxie d'au moins un matériau III-V de manière à définir au moins un ensemble de couches de base élémentaires en matériau III-V (201i) dans lesdites premières ouvertures ;
- la réalisation d'un ensemble de seconds motifs dans un matériau diélectrique (200) de manière à définir un ensemble de secondes ouvertures (Oᵢ₂) présentant un recouvrement avec lesdites couches de base élémentaires en matériau III-V ;
- une seconde opération d'épitaxie d'au moins un matériau III-V à la surface desdites couches de base élémentaires en matériau III-V de manière à réaliser lesdites structures élémentaires en matériau(x) III-V présentant une face externe ;
- une opération de report et d'assemblage de l'ensemble des structures élémentaires via leur face externe, sur une interface (300) pouvant comporter des éléments passifs et/ou des éléments actifs, ladite interface étant réalisée à la surface d'un second substrat à base de silicium (301) ;
- le retrait dudit premier substrat à base de silicium et de l'ensemble des couches de base élémentaires en matériau III-V située sur lesdites structures élémentaires.

14. Procédé selon la revendication 13 dans lequel on réalise plusieurs structures élémentaires actives photoniques (202i, 202j, 202k, 202l) différentes fonctionnant à des longueurs d'onde différentes.

15. Procédé selon l'une des revendications 13 ou 14, comprenant des opérations successives d'épitaxie pour réaliser les différentes structures élémentaires, lesdites opérations étant effectuées successivement à des températures d'épitaxie décroissantes.

16. Procédé selon l'une des revendications précédentes dans le lequel un support (303) est situé sur la face opposée audit second substrat, ledit procédé comprenant le retrait dudit second substrat avant assemblage, pour laisser à nu l'interface pouvant comporter des éléments passifs et/ou actifs, ladite interface étant à la surface dudit support (303).

17. Procédé selon l'une des revendications 2 à 14, dans lequel la au moins structure élémentaire active photonique (202i) comprend une structure à multi-puits quantique en matériau(x) III-V.

18. Procédé selon l'une des revendications précédentes dans lequel la au moins couche de base élémentaire en matériau III-V (201i) est en InP.

## Patentansprüche

1. Herstellungsverfahren einer Heterostruktur, welche mindestens eine Elementarstruktur aus III-V-Material an der Oberfläche einesSubstrates auf Siliziumbasis umfasst, nacheinander folgende Schritte umfassend:
- die Schaffung eines ersten Motivs, welches mindestens eine erste Öffnung (Oᵢ₁) aufweist, in einem dielektrischen Material (200) an der Oberfläche eines ersten Substrates auf Siliziumbasis (100);
- einen ersten Epitaxie-Schritt mindestens eines III-V-Materials, um mindestens eine elementare Basisschicht aus III-V-Material (201i) in der mindestens einen ersten Öffnung zu definieren;
- die Schaffung eines zweiten Motivs in einem dielektrischen Material (200), um mindestens eine zweite Öffnung (Oᵢ₂) zu definieren, welche eine Überlappung mit der mindestens einen elementaren Basisschicht aus III-V-Material aufweist;
- einen zweiten Epitaxie-Schritt mindestens eines III-V-Materials an der Oberfläche der mindestens einen elementaren Basisschicht aus III-V-Material, um die mindestens eine Elementarstruktur aus III-V-Material(ien) zu schaffen, welche eine Außenseite aufweist;
- einen Schritt des Übertragens und der Montage der mindestens einen Elementarstruktur über ihre Außenseite, auf eine Schnittstelle (300), welche passive und/oder aktive Elemente umfassen kann, wobei die Schnittstelle an der Oberfläche eines zweiten Substrates auf Siliziumbasis (301) geschaffen ist;
- Entfernen des ersten Substrates auf Siliziumbasis und der mindestens elementaren Basisschicht aus III-V-Material, welche auf der Elementarstruktur angeordnet ist.

2. Verfahren nach Anspruch 1, wobei die mindestens Elementarstruktur eine aktive photonische Elementarstruktur ist.

3. Verfahren nach einem der Ansprüche 1 oder 2, wobei die mindestens Elementarstruktur eine passive Elementarstruktur ist.

4. Verfahren nach einem der Ansprüche 1 bis 3, umfassend Polierschritte, welche mechanisch-chemisch (CMP) sein können, welche nach den Epitaxie-Schritten ausgeführt werden.

5. Verfahren nach Anspruch 4, umfassend einen mechanisch-chemischen Polierschritt (CMP) vor dem Schritt des Übertragens und der Montage.

6. Verfahren nach einem der Ansprüche 1 bis 5, bei welchem die Schaffung des ersten Motivs Folgendes umfasst:
- die Schaffung mindestens einer primären Öffnung, welche mindestens einen vertikalen unteren Abschnitt und einen vertikalen oberen Abschnitt aufweist, wobei der vertikale Abschnitt in Bezug auf den horizontalen Abschnitt dezentriert ist;
- die Schaffung mindestens einer elementaren Basisschicht aus III-V-Material, umfassend einen vertikalen unteren Abschnitt und einen horizontalen Abschnitt;
- die Schaffung der mindestens aktiven photonischen Elementarstruktur auf der Oberfläche des horizontalen Abschnitts der elementaren Basisschicht aus III-V-Material, dezentriert in Bezug auf den vertikalen unteren Abschnitt der mindestens einen elementaren Basisschicht aus III-V-Material.

7. Verfahren nach Anspruch 6, wobei die Schaffung des ersten Motivs die Schaffung mindestens einer komplexen primären Öffnung (O'ᵢ₁) umfasst, welche mindestens Folgendes aufweist:
- einen vertikalen unteren Abschnitt;
- einen horizontalen Zwischenabschnitt;
- einen vertikalen oberen Abschnitt;
- wobei der vertikale untere und obere Abschnitt dem horizontalen Abschnitt abgewandt dezentriert sind;
- wobei der erste Epitaxie-Schritt mindestens eine elementare Basisschicht aus primärem III-V-Material definiert, welche mindestens einen vertikalen unteren Abschnitt und einen horizontalen Abschnitt aufweist.

8. Verfahren nach Anspruch 7, Folgendes umfassend:
- die Schaffung des vertikalen unteren Abschnitts und des horizontalen Zwischenabschnitts;
- das Ablagern eines Opfermaterials in dem vertikalen unteren Abschnitt und in dem horizontalen Zwischenabschnitt, um mindestens ein Opfer-Zwischenelement (203i) zu definieren;
- Ablagern einer oberen Dielektrikumsschicht (200);
- die Schaffung des mindestens einen vertikalen oberen Abschnitts der ersten Öffnung in der oberen Dielektrikumsschicht, um mindestens die erste komplexe Öffnung (O'1i) zu bilden;
- die Epitaxie aus III-V-Material in der mindestens der primären komplexen Öffnung, um die mindestens elementare Basisschicht aus III-V-Material (201i) zu bilden.

9. Verfahren nach Anspruch 8, wobei das Opfermaterial Si₁₋ₓ,Geₓ ist, wobei 0 < x < 1, polykristallin oder amorph ist.

10. Verfahren nach Anspruch 9, wobei das Entfernen des Opfermaterials in einer gasförmigen Mischung aus gasförmigem HCl und Di-Wasserstoff bei einer Temperatur über 500°C erfolgt.

11. Verfahren nach einem der Ansprüche 1 bis 9, wobei der Montageschritt einen Klebeschritt umfasst.

12. Verfahren nach Anspruch 11, wobei der Klebeschritt ein Molekularklebeschritt ist.

13. Verfahren nach einem der vorhergehenden Ansprüche, Folgendes umfassend:
- die Schaffung einer Gruppe erster Motive, welche erste Öffnungen (Oᵢ₁) aufweisen, in einem dielektrischen Material (200) auf der Oberfläche eines ersten Substrates auf Siliziumbasis (100);
- einen ersten Epitaxie-Schritt mindestens eines III-V-Materials, um mindestens eine Gruppe von elementaren Basisschichten aus III-V- Material (201i) in den ersten Öffnungen zu definieren;
- die Schaffung einer Gruppe zweiter Motive in einem dielektrischen Material (200), um eine Gruppe zweiter Öffnungen (Oᵢ₂) zu definieren, welche eine Überlappung mit den elementaren Basisschichten aus III-V-Material aufweist;
- einen zweiten Epitaxie-Schritt mindestens eines III-V-Materials auf der Oberfläche der elementaren Basisschichten aus III-V-Material, um die Elementarstrukturen aus III-V-Material(ien) zu schaffen, welche eine Außenseite aufweisen;
- einen Schritt des Übertragens und der Montage der gesamten Elementarstrukturen über ihre Außenseite, auf eine Schnittstelle (300), welche passive und/oder aktive Elemente umfassen kann, wobei die Schnittstelle auf der Oberfläche eines zweiten Substrates auf Siliziumbasis (301) geschaffen ist;
- Entfernen des ersten Substrates auf Siliziumbasis und der gesamten elementaren Basisschichten aus III-V-Material, welche auf der Elementarstruktur angeordnet sind.

14. Verfahren nach Anspruch 13, wobei mehrere unterschiedliche aktive photonische Elementarstrukturen (202i, 202j, 202k, 202l) erschaffen werden, welche bei unterschiedlichen Wellenlängen arbeiten.

15. Verfahren nach einem der Ansprüche 13 oder 14, umfassend aufeinanderfolgende Epitaxie-Schritte zum Schaffen der unterschiedlichen Elementarstrukturen, wobei die Schritte nacheinander bei absteigenden Epitaxie-Temperaturen ausgeführt werden.

16. Verfahren nach einem der vorhergehenden Ansprüche, wobei ein Träger (303) an der dem zweiten Substrat abgewandten Seite angeordnet ist, wobei das Verfahren das Entfernen des zweiten Substrates vor der Montage umfasst, um die Schnittstelle bloßzulegen, welche passive und/oder aktive Elemente umfassen kann, wobei die Schnittstelle auf der Oberfläche des Trägers (303) angeordnet ist.

17. Verfahren nach einem der Ansprüche 2 bis 14, wobei die mindestens aktive photonische Elementarschicht (202i) eine Struktur mit mehreren Quantentöpfen aus III-V-Material(ien) umfasst.

18. Verfahren nach einem der vorhergehenden Ansprüche, wobei die mindestens elementare Basisschicht aus III-V-Material (201i) aus InP besteht.

## Claims

1. Method for fabricating a heterostructure having at least an elementary structure made of III-V material on the surface of a silicon-based substrate successively comprising:
- producing a first pattern having at least a first opening (Oᵢ₁) in a dielectric material (200) on the surface of a first silicon-based substrate (100);
- a first operation for epitaxy of at least a III-V material so as to define at least an elementary base layer made of III-V material (201i) in said at least first opening;
- producing a second pattern in a dielectric material (200) so as to define at least a second opening (Oᵢ₂) having an overlap with said at least elementary base layer made of III-V material;
- a second operation for epitaxy of at least a III-V material on the surface of said at least elementary base layer made of III-V material so as to produce said at least elementary structure made of III-V material(s) having an outer face;
- an operation for transferring and assembling said at least elementary structure via its outer face, on an interface (300) that may have passive elements and/or active elements, said interface being produced on the surface of a second silicon-based substrate (301);
- removing said first silicon-based substrate and said at least elementary base layer made of III-V material located on said elementary structure.

2. Method according to claim 1, wherein said at least elementary structure is an active photonic elementary structure.

3. Method according to any of claim 1 or claim 2, wherein said at least elementary structure is a passive elementary structure.

4. Method according to one of claims 1 to 3, comprising polishing operations that may be of chemical-mechanical type (CMP), carried out after the epitaxy operations.

5. Method according to claim 4, comprising a chemical-mechanical polishing (CMP) operation prior to the transfer and assembly operation.

6. Method according to one of claims 1 to 5, wherein the production of said first pattern comprises:
- producing at least a primary opening having at least a lower vertical portion and an upper horizontal portion, said vertical portion being off-center with respect to said horizontal portion;
- producing at least an elementary base layer made of III-V material comprising a lower vertical portion and a horizontal portion;
- producing at least said photonic active elementary structure on the surface of the horizontal portion of said elementary base layer made of III-V material, in an off-center manner with respect to the lower vertical portion of said at least elementary base layer made of III-V material.

7. Method according to claim 6, wherein the production of said first pattern comprises the production of at least a complex primary opening (O'ᵢ₁) having at least:
- a lower vertical portion;
- an intermediate horizontal portion;
- an upper vertical portion;
- said lower and upper vertical portions being off-center in an opposite manner with respect to said horizontal portion;
- said first epitaxy operation defining at least an elementary base layer made of primary III-V material having at least a lower vertical portion and a horizontal portion.

8. Method according to claim 7, comprising:
- producing said lower vertical portion and said intermediate horizontal portion;
- depositing a sacrificial material in said lower vertical portion and in said intermediate horizontal portion so as to define at least an intermediate sacrificial element (203i);
- depositing an upper dielectric layer (200);
- producing at least said upper vertical portion of said first opening in said upper dielectric layer so as to form at least said first complex opening (O'1i);
- epitaxy of III-V material in said at least complex primary opening, so as to form said at least said elementary base layer made of III-V material (201i).

9. Method according to claim 8, wherein the sacrificial material is Si₁₋ₓGeₓ with 0 < x <1, which is polycrystalline or amorphous.

10. Method according to claim 9, wherein the removal of said sacrificial material is carried out in a mixture of gaseous HCl and dihydrogen at a temperature above 500°C.

11. Method according to one of claims 1 to 9, wherein said assembly operation comprises a bonding operation.

12. Method according to claim 11, wherein said bonding operation is a molecular bonding operation.

13. Method according to one of the preceding claims, comprising:
- producing a set of first patterns having first openings (Oᵢ₁) in a dielectric material (200) on the surface of a first silicon-based substrate (100);
- a first operation for epitaxy of at least a III-V material so as to define at least a set of elementary base layers made of III-V material (201i) in said first openings;
- producing a set of second patterns in a dielectric material (200) so as to define a set of second openings (Oᵢ₂) having an overlap with said elementary base layers made of III-V material;
- a second operation for epitaxy of at least a III-V material on the surface of said elementary base layers made of III-V material so as to produce said elementary structures made of III-V material(s) having an outer face;
- an operation for transferring and assembling all of the elementary structures via their outer face, on an interface (300) that may comprise passive elements and/or active elements, said interface being produced on the surface of a second silicon-based substrate (301);
- removing said first silicon-based substrate and all of the elementary base layers made of III-V material located on said elementary structures.

14. Method according to claim 13, wherein several different photonic active elementary structures (202i, 202j, 202k, 2021) operating at different wavelengths are produced.

15. Method according to any of claim 13 or claim 14, comprising successive epitaxy operations to produce the various elementary structures, said operations being carried out successively at decreasing epitaxy temperatures.

16. Method according to one of the preceding claims, wherein a support (303) is located on the face opposite to said second substrate, said method comprising the removal of said second substrate before assembly, to leave exposed the interface that may comprise passive and/or active elements, said interface being on the surface of said support (303).

17. Method according to one of claims 2 to 14, wherein the at least photonic active elementary structure (202i) comprises a multiple quantum well structure made of III-V material(s).

18. Method according to one of the preceding claims, wherein the at least elementary base layer made of III-V material (201i) is made of InP.
